# DEMANDE DE BREVET EUROPEEN

(11) **EP 1 811 829 A1**
(43) Date de publication de la demande: **25.07.2007**
(21) Numéro de dépôt: 07105949.7
(22) Date de dépôt: 08.09.2003
(51) Int. Cl.: H05K 13/04, H01L 21/00, B65G 47/14, H05K 13/02

(54) **Méthode et dispositif pour l'extraction de composants électroniques hors de tubes et dispositif d'alimentation en composants électroniques**

(30) Priorité: 07.03.2003 CH 3662003
(62) Demande divisionnaire de: 03812114.1
(71) Demandeur: ISMECA Semiconductor Holding SA, 2300 La Chaux-de-Fonds (CH)
(72) Inventeur: Remonnay, Emmanuel, 25130, Villiers le Lac (FR); Ehrensperger, Jean-Pierre, 2300, La Chaux-de-Fonds (CH); Chenal, Pierre-Alain, 2416, Les Brenets (CH)
(74) Mandataire: P&TS Patents & Technology Surveys SA

(57) **Abrégé**

Méthode pour l'extraction de composants électroniques (8, 8', 8") hors d'un tube (7), les composants électroniques (8, 8', 8") étant extraits du tube (7) à l'aide de moyens pneumatiques. Dispositif pour l'extraction de composants électroniques (8, 8', 8") hors d'un tube (7), comprenant un système pneumatique pour l'extraction des composants électroniques (8, 8', 8") hors du tube (7) et dispositif pour l'alimentation en composants électroniques (8, 8', 8") d'une ligne de traitement (9), comprenant un tel dispositif d'extraction. L'utilisation de moyens pneumatiques pour l'extraction des composants électroniques (8, 8', 8") offre entre autres avantages celui de permettre au tube (7) de rester en position horizontale tout en évitant l'utilisation de moyens mécaniques délicats et compliqués.

## Description

La présente invention concerne une méthode et un dispositif pour extraire des composant électroniques hors de tubes, ainsi qu'un dispositif d'alimentation en composants électroniques comprenant un tel dispositif.

Les composants électroniques sont couramment conditionnés dans des tubes, généralement en plastique antistatique rigide et de section globalement rectangulaire, leur offrant une bonne protection mécanique et facilitant en particulier leur transport. Dans certains cas, le profil du tube est spécifiquement adapté au type de composants qu'il contient, par exemple à la forme et à la répartition de leurs broches. Lors de leur conditionnement, les composants sont glissés un à un dans un tube, dans lequel ils sont maintenus les uns derrière les autres. Les tubes sont fermés à chaque extrémité par un bouchon généralement sommaire destiné à empêcher les composants d'en sortir.

Afin de pouvoir être traités ultérieurement, par exemple par une ligne de test ou par un dispositif de population de circuits imprimés, les composants doivent être extraits des tubes. Cette opération est généralement effectuée par un dispositif d'alimentation qui, après avoir extrait les composants électroniques des tubes, les transporte jusqu'à un emplacement d'où ils seront par exemple transférés sur la ligne de test ou sur le dispositif de population de circuits imprimés.

La plupart des dispositifs de l'art antérieur utilisent la force de gravitation pour faire glisser les composants hors des tubes. Un des deux bouchons fermant les deux extrémités de chaque tube est enlevé. Les tubes contenant les composants sont ensuite placés, généralement horizontalement, dans un réservoir d'où ils sont prélevés l'un après l'autre. L'extrémité fermée du tube prélevé est surélevée à l'aide d'un mécanisme souvent complexe, faisant ainsi glisser les composants électroniques vers l'extrémité ouverte du tube. Cependant, les composants devant de préférence être placés horizontalement pour leur transfert sur un autre dispositif, leur orientation au sortir du tube doit être corrigée. Les composants sont ainsi généralement glissés depuis le tube sur un convoyeur parabolique qui les amènera dans la position désirée.

Ces dispositifs de l'art antérieur présentent plusieurs désavantages. Le mécanisme permettant de surélever une extrémité du composant est souvent compliqué et sa vitesse de traitement est limitée. En outre, les convoyeurs paraboliques sont délicats et coûteux à réaliser. Il s'agit généralement de guides au profil bien précis le long duquel les composants glissent sous l'effet de la gravité. Avec l'augmentation générale de la cadence des lignes de traitement et la diminution de la taille des composants, ces guides doivent être usinés avec une très grande précision afin que les composants puissent y glisser avec le débit et la précision nécessaires. A chaque changement du type de composants traités par le dispositif, un nouveau guide doit être installé, impliquant souvent de longs réglages durant lesquels le dispositif n'est pas opérationnel.

Afin d'éviter ces désavantages, certains dispositifs d'alimentation de l'art antérieur font usage de mécanismes de poussée permettant d'extraire les composants tandis que le tube est en position horizontale. Le tube est généralement aligné avec un convoyeur linéaire amenant les composants extraits à l'emplacement d'où ils seront par exemple transférés sur une ligne de traitement. Bien que ces dispositifs ne nécessitent ni de mécanisme pour surélever le tube, ni de moyens pour corriger l'orientation des composants tels que par exemple un rail parabolique, les mécanismes de poussée utilisés sont généralement complexes et leur cadence est souvent limitée.

La demande de brevet US 2002/00667980 décrit par exemple un dispositif d'alimentation dont le mécanisme de poussée comprend un ruban d'acier qui est introduit dans le tube par une de ses extrémités afin de pousser les composants vers l'autre extrémité. Un tel mécanisme est très complexe et délicat, principalement en raison du contrôle des mouvements du mécanisme de poussée qui doit être précis et synchronisé avec la cadence du dispositif suivant, par exemple de la ligne de traitement qui prélève les composants extraits. De plus, les bouchons doivent être enlevés aux deux extrémités du tube avant que ce dernier ne soit placé dans le réservoir du dispositif d'alimentation, ce qui représente des manipulations supplémentaires pour chaque tube traité par le dispositif.

Le brevet US 4770565 décrit quant à lui un dispositif dans lequel les composants électroniques sont extraits de leur tube de transport par aspiration. Une extrémité du tube de transport est insérée dans un adaptateur qui est relié de l'autre côté à un convoyeur tubulaire amenant les composants vers la position d'où ils seront prélevés, par exemple par une machine de placement. De l'air est pulsé dans l'adaptateur en direction du convoyeur, créant un vide d'air partiel à l'embouchure du tube de transport. Les composants sont ainsi aspirés hors du tube vers l'adaptateur. Un tel système présente toutefois le désavantage majeur que l'extraction des composants de leur tube de transport, en particulier la régularité et la vitesse de cette extraction, est difficilement contrôlable. En effet, le vide d'air partiel aspirant les composants hors de leur tube est généré par un flux d'air comprimé dirigé vers la sortie opposée de l'adaptateur. L'intensité du vide d'air à l'arrière de ce flux, et par conséquent la force avec laquelle les composants sont extraits, ne peut de cette manière être contrôlée avec précision. De plus, à l'intérieur de l'adaptateur les composants passent d'une zone de vide partiel à l'arrière du flux d'air, à une zone de surpression après la buse par laquelle l'air est pulsé. Ils doivent ainsi traverser une zone de turbulences dans laquelle leur déplacement linéaire est fortement perturbé, augmentant sensiblement les risques de blocage. La forme et les dimensions de l'adaptateur sont en outre spécifiquement adaptés à un seul type de tubes de transport et à un seul type de composants. Si le dispositif doit traiter successivement différents types de composants conditionnés dans différents tubes de transport, il doit à chaque fois être équipé d'un nouvel adaptateur, et éventuellement d'un nouveau convoyeur.

Le brevet US 5368193 décrit quant à lui un boîtier pour composants électroniques comprenant un réservoir en spirale. Ce document décrit également un dispositif d'alimentation adapté permettant de souffler de l'air par des orifices prévus à cet effet dans le boîtier afin d'en extraire les composants. L'utilisation d'un tel dispositif est cependant très limitée puisqu'il est spécifiquement adapté à ce type de boîtiers qui ne correspondent à aucun standard de l'industrie.

Un but de la présente invention est donc de proposer une méthode et un dispositif pour l'extraction de composants électroniques ne présentant pas les désavantages des méthodes et dispositifs de l'art antérieur.

Ce but est atteint par une méthode et un dispositif possédant les caractéristiques de la revendication indépendante correspondante, des variantes avantageuses étant données par les revendications dépendantes.

Ce but est atteint en particulier par une méthode pour l'extraction de composants électroniques hors d'un tube, selon laquelle les composants électroniques sont extraits du tube à l'aide de moyens pneumatiques. Ce but est également atteint par un dispositif pour l'extraction de composants électroniques hors d'un tube, comprenant un système pneumatique pour l'extraction des composants électroniques et par un dispositif pour l'alimentation en composants électroniques d'une ligne de traitement comprenant un tel dispositif d'extraction. L'utilisation de moyens pneumatiques pour l'extraction des composants électroniques offre entre autres avantages celui de permettre au tube de rester en position horizontale tout en évitant l'utilisation de moyens mécaniques délicats et compliqués.

La présente invention sera mieux comprise à l'aide de la description d'une version préférentielle, illustrée par les figures 1 à 6, où:
la figure 1 est une vue latérale d'un dispositif d'alimentation comprenant un dispositif d'extraction selon une version préférentielle de l'invention,
la figure 2 est une vue de dessus du dispositif de la figure 1,
la figure 3a est une coupe partielle selon l'axe III-III du dispositif des figures 1 et 2,
la figure 3b illustre le fonctionnement du mécanisme d'ouverture du réservoir du dispositif des figure 1 et 2,
la figure 4 est une vue partielle du dispositif d'extraction selon une version préférentielle de l'invention,
la figure 5 est une coupe selon l'axe V-V du dispositif de la figure 4,
la figure 6 est une coupe similaire à la coupe de la figure 5 lors de l'utilisation du dispositif d'extraction pour un autre type de tubes.

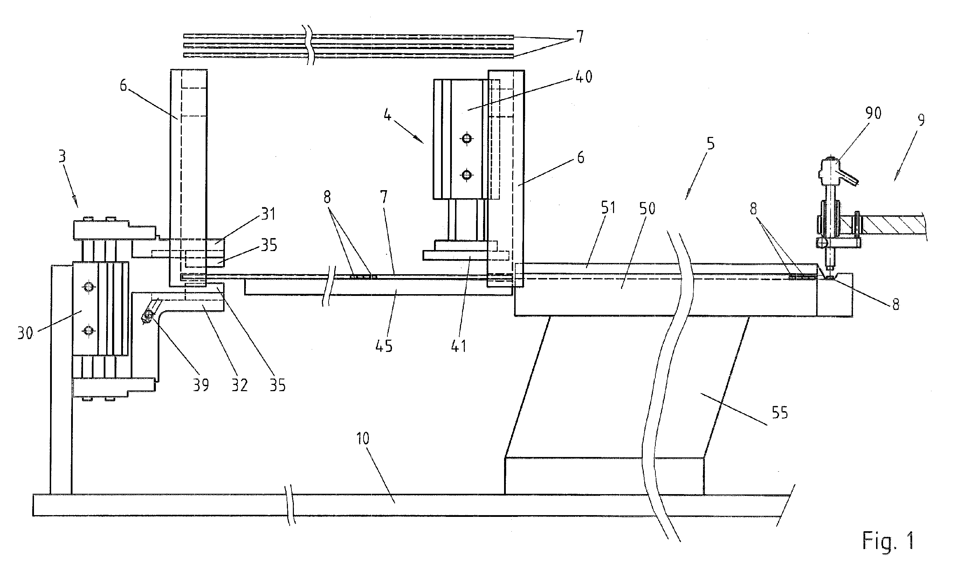

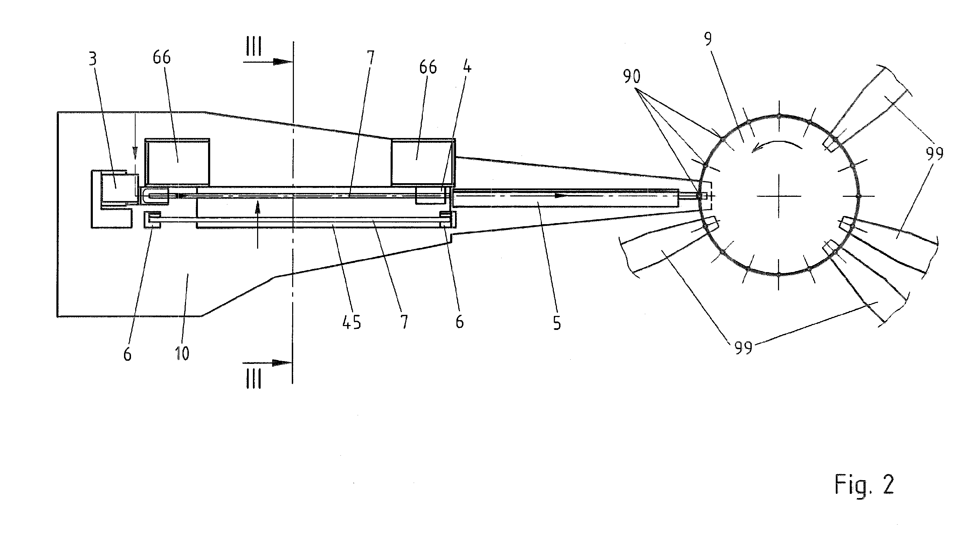

Dans une version préférentielle, le dispositif d'extraction de l'invention est intégré à un dispositif d'alimentation en composants électroniques destiné à collaborer avec une ligne de traitement, par exemple une ligne de test et/ou de conditionnement, articulée autour d'un convoyeur circulaire 9 (figures 1 et 2). Le dispositif d'alimentation extrait les composants électroniques 8 des tubes 7 et les met à disposition du convoyeur circulaire 9. Le convoyeur circulaire 9 est équipé sur sa périphérie de porte-composants, par exemple des têtes d'aspiration 90, permettant de prélever les composants 8 et de les transporter sur les autres postes 99 de la ligne de traitement, partiellement représentés sur la figure 2, tels que par exemple des postes de test, de marquage et/ou de conditionnement.

Le dispositif d'alimentation, à l'instar des autres postes 99, est avantageusement fixé sur une plaque de support 10 comportant par exemple des éléments de fixation non représentés destinés à collaborer avec des éléments de fixation sur un plateau fixe non représenté, situé de préférence sous le convoyeur circulaire 9. La ligne de traitement est ainsi formée de façon modulaire par la fixation autour du convoyeur circulaire 9, sur le plateau fixe non représenté, des différents postes de traitement la constituant. La position de chaque poste de traitement par rapport au convoyeur 9 est précisément déterminée par l'emplacement précis et les dimensions exactes des éléments de fixation respectifs.

Dans une version préférentielle, le dispositif d'alimentation de l'invention comprend un convoyeur, de préférence un convoyeur linéaire 5, pour le transport des composants électroniques 8 extraits des tubes 7 vers l'emplacement d'où ils seront prélevés par les têtes d'aspiration 90 du convoyeur circulaire 9. Le convoyeur linéaire 5 est par exemple un convoyeur vibratoire sur lequel les composants électroniques 8 se déplacent sous l'effet des vibrations d'un vibreur 55 électromagnétique ou piézoélectrique. Le convoyeur linéaire 5 comprend par exemple une base 50 fixée sur le vibreur 55 et sur laquelle est formé un rail pour guider le mouvement des composants. Le profil du rail est avantageusement adapté au type de composants à convoyer. Il est de préférence similaire au profil intérieur des tubes 7. La base 50 est surmontée d'un couvercle 51 empêchant les composants de sortir involontairement du rail. Selon les configurations, la face inférieure du couvercle 51 peut également être profilée afin de contribuer au guidage des composants.

Le dispositif d'extraction de l'invention sur lequel les tubes 7 sont vidés de leurs composants électroniques 8 est placé près de l'extrémité du convoyeur linéaire 5 opposée au convoyeur circulaire 9. Il est disposé de manière à ce que, lors de l'extraction des composants électroniques 8, le tube 7 à vider soit aligné par rapport au convoyeur linéaire 5. Les composants électroniques 8 extraits du tube 7 y sont ainsi directement introduits.

Le dispositif d'extraction comprend un support 45 sur lequel, durant l'extraction des composants électroniques 8, le tube 7 est de préférence maintenu par des moyens mécaniques, par exemple par une presse 4 comprenant un sabot 41 pour appuyer sur le tube 7 sans l'endommager, lié à un actuateur linéaire 40.

Une pince 3 comprenant deux mâchoires 31, 32 mues par exemple par un actuateur linéaire 30 est disposée de manière à pouvoir enserrer l'extrémité du tube 7 opposée au convoyeur linéaire 5. Un dégagement aux dimensions supérieures à celles du tube 7 est formée à l'intérieur des mâchoires 31, 32. Il est au moins partiellement rempli par une matière déformable et compressible, par exemple une mousse étanche 35, épousant le profil extérieur du tube 7 lorsque la pince 3 est fermée sur ce dernier. La pince 3 est reliée à un système pneumatique non représenté à travers une conduite 39 pratiquée par exemple dans la mâchoire inférieure 32.

Le dispositif d'alimentation comprend de préférence un réservoir, disposé de préférence parallèlement au dispositif d'extraction, permettant d'accueillir un certain nombre de tubes 7 pouvant contenir des composants électroniques 8. Le réservoir est par exemple constitué de deux rails 6 disposés sensiblement verticalement et disposés de manière à ce que, par leur profil en U par exemple, chacun maintienne une extrémité des tubes 7 se trouvant dans le réservoir, les empêchant ainsi de se déplacer dans le plan horizontal tout en leur permettant de glisser verticalement. Des moyens mécaniques non représentés permettent le transfert des tubes 7 du réservoir vers le dispositif d'extraction. Des bacs de récupération 66 visibles sur la figure 2, situés par exemple de l'autre côté du dispositif d'extraction, recueillent les tubes vides.

Les tubes 7 contenant les composants électroniques 8 devant être introduits sur la ligne de traitement par le dispositif d'alimentation sont ainsi disposés les uns sur les autres dans le réservoir. Pour empêcher les composants électroniques 8 de sortir, les tubes 7 sont habituellement fermés à leurs deux extrémités par un bouchon généralement sommaire, constitué par exemple d'un morceau de mousse ou de plastique introduit dans le tube 7 ou d'un clou en plastique traversant le tube 7 selon un axe perpendiculaire à son axe longitudinal. Avant leur introduction dans le réservoir, au moins une extrémité de chaque tube 7 est débouchée, généralement manuellement, afin de permettre l'extraction des composants électroniques 8. Les tubes 7 sont donc disposés dans le réservoir de manière à ce que leur extrémité ouverte soit située du côté du convoyeur linéaire 5. Les tubes 7 sont ensuite transférés un à un du réservoir vers le dispositif d'extraction pour y être vidés de leurs composants.

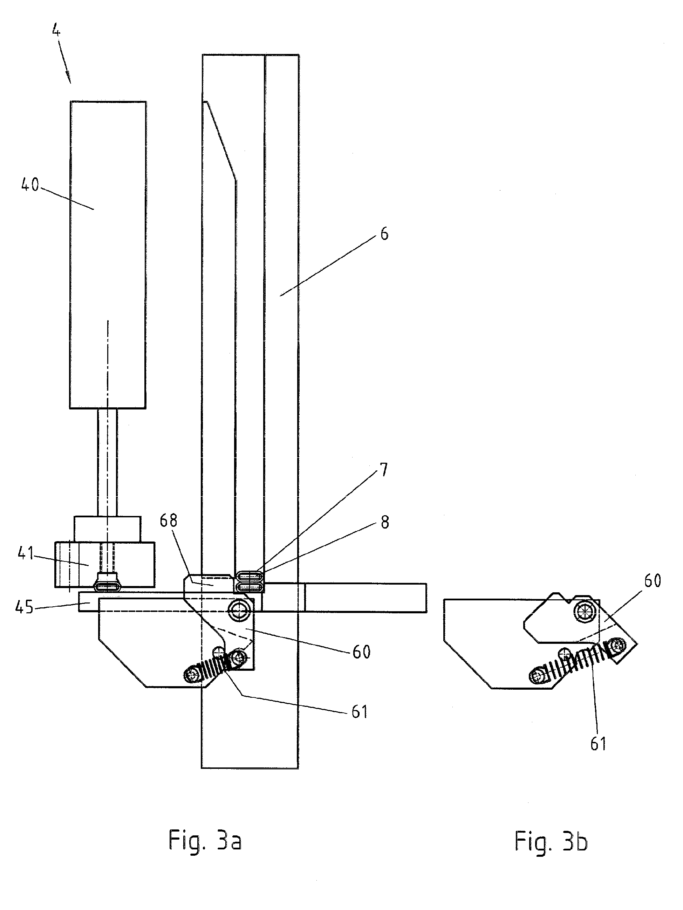

La figure 3a montre un détail du réservoir et une partie des moyens mécaniques permettant le transfert des tubes 7 de ce dernier vers le dispositif d'extraction. A son extrémité inférieure, le profil du rail 6 maintenant l'extrémité des tubes 7 dans le plan horizontal est ouvert afin de permettre le passage du tube 7 inférieur. Ce dernier est maintenu dans le réservoir par au moins un arrêt 60. Un actuateur non représenté permet de faire pivoter l'arrêt 60 autour de son axe (figure 3b), libérant ainsi le tube inférieur qui peut alors être poussé sur le support 45 par des moyens mécaniques non représentés en direction du dispositif d'extraction. Une fois dans l'axe du convoyeur linéaire, le tube 7 est maintenu dans sa position par le sabot 41 dont le profil inférieur est de préférence formé afin d'assurer, voire de corriger, son alignement par rapport au convoyeur linéaire.

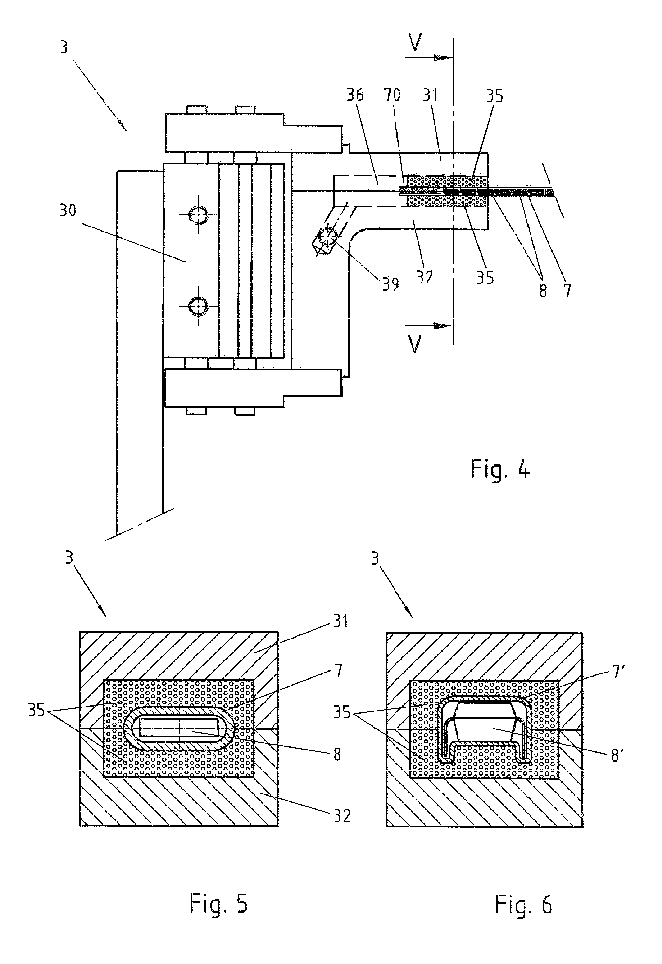

La pince 3 est fermée sur l'extrémité du tube 7 (figure 4). Comme illustré à la figure 5, la mousse étanche 35 à l'intérieur des mâchoires 31, 32 épouse alors fidèlement le profil extérieur du tube 7. La portion des dégagements formés dans les mâchoires 31, 32 qui ne sont pas remplies de mousse 35 forment alors une chambre 36 fermée hermétiquement, reliée par l'intermédiaire de la conduite 39 au système pneumatique non représenté.

L'homme du métier comprendra cependant qu'il est également possible de fermer hermétiquement la chambre 36 autour du tube 7 par d'autres moyens que la mousse 35. Il serait par exemple envisageable de prévoir des mâchoires dont le profil serait parfaitement adapté au profil extérieur du tube 7, équipées éventuellement de joints en matière plastique en améliorant encore l'étanchéité. L'avantage de la solution proposée dans la variante préférentielle de l'invention décrite plus haut est cependant illustré à la figure 6. Il est en effet possible, grâce aux propriétés de la mousse 35 déformable et compressible, d'utiliser la même pince 3 pour l'extraction de plusieurs types de composants électroniques, conditionnés dans des tubes aux profils extérieurs très différents. La mousse 35 épouse ainsi aussi bien le profil d'un tube 7 au profil globalement elliptique ou rectangulaire contenant par exemple des composants électroniques 8 sans pattes, que le profil d'un tube 7' adapté par exemple au conditionnement de composants électroniques 8' possédant des pattes de sorties.

Lorsque la pince est fermée, la mousse 35 ne recouvre de préférence pas toute l'extrémité du tube 7 qui se retrouve ainsi dans la chambre 36. Afin d'extraire les composants 8 du tube 7, de l'air comprimé est amené de préférence en continu par le système pneumatique dans la chambre 36, à travers la conduite 39, y générant ainsi une surpression. Le bouchon 70 fermant l'extrémité du tube 7 n'étant pas hermétique, la surpression générée dans la chambre 36 se propage dans le tube 7 depuis l'extrémité se trouvant dans la chambre 36, poussant les composants 8 vers l'extrémité ouvert du tube 7, qui est alignée avec le convoyeur linéaire 5. Les composants 8 sont ainsi expulsés en un flot continu du tube 7 par la surpression générée dans la chambre 36 et transférés l'un après l'autre sur le convoyeur linéaire 5. L'homme du métier comprendra cependant qu'il est également envisageable dans le cadre de l'invention d'expulser les composants 8 un à un du tube 7 par de courtes impulsions successives d'air comprimé, par exemple.

Lorsque le tube 7 est entièrement vidé de ses composants 8, par exemple après une période déterminée d'application de la surpression, la pince 3 est ouverte et le sabot 41 est levé. Le tube 7 est alors évacué dans les bacs 66 en contrebas du support 45 par des moyens mécaniques non représentés. Un nouveau tube 7 peut ensuite être amené du réservoir vers le dispositif d'extraction.

Le fonctionnement du dispositif d'alimentation est de préférence entièrement automatisé et contrôlé par un système de contrôle non représenté. Le système de contrôle commande ainsi avantageusement tous les éléments du dispositif, en particulier les actuateurs et le système pneumatique, et traite les éventuels signaux reçus par exemple de divers capteurs, senseurs ou autres éléments de contrôle permettant de surveiller le bon fonctionnement du dispositif et de détecter les éventuelles pannes. La commande et le contrôle centralisés et automatisés de l'ensemble des opérations permet au dispositif d'alimentation d'optimiser sa cadence de travail, grâce en particulier à la parfaite synchronisation de tous ses éléments.

Selon l'invention, le dispositif d'extraction fait appel à des moyens pneumatiques pour extraire les composants 8 de leurs tubes 7, permettant à ces derniers de rester en position horizontale durant toute l'opération. Le dispositif d'extraction de l'invention permet ainsi d'éviter l'utilisation des moyens mécaniques complexes généralement nécessaires pour surélever les tubes dans les dispositif faisant appel à la force de gravité. Les moyens mécaniques pour la mise en oeuvre du procédé de l'invention sont également nettement plus simples et robustes que les dispositifs de poussée utilisés par les dispositifs d'extraction de l'art antérieur permettant l'extraction des composants hors de tube placés horizontalement.

L'utilisation de moyens pneumatiques pour l'extraction des composants permet en outre au dispositif de l'invention d'atteindre des cadences plus élevées que les cadences des dispositifs de l'art antérieur, notamment des dispositifs faisant usage de la force de gravité.

Un avantage supplémentaire du dispositif d'extraction de l'invention est qu'il permet de faire circuler les composants 8 dans les deux sens dans le tube 7.

Les dimensions des composants électroniques actuels tendent à être toujours plus réduites. De plus, afin d'augmenter encore la capacité des tubes, ils y sont souvent placés dans le sens de la largeur. C'est-à-dire que leur plus grande dimension est placée perpendiculairement à l'axe longitudinal du tube. Ces deux facteurs diminuent ainsi la tenue latérale des composants dans leur tube, leur permettant de se placer légèrement de biais. II est donc relativement fréquent qu'un composant électronique soit suffisamment de travers pour que par exemple un de ses angles se coince contre la paroi interne du tube, bloquant également les composants suivants. Dans de telles situations, l'application d'une force supplémentaire sur les composants en direction de la sortie du tube ne résout en rien le problème. Le composant bloqué a en effet tendance à se coincer encore plus dans le tube.

Les dispositifs d'extraction de l'art antérieur n'offrent généralement aucune solution automatique à ce problème: le tube partiellement vidé est retiré du dispositif, le composant bloqué est remis manuellement en place et le tube est réintroduit sur le dispositif. Ce procédé nécessite un travail supplémentaire conséquent, outre le fait que la présence de composants bloqués peut ne pas être détectée, entraînant le risque qu'ils soient jetés avec le tube considéré comme vide.

Selon une version préférentielle de l'invention, le système pneumatique permet non seulement d'introduire de l'air comprimé à l'intérieur de la chambre 36, mais il permet également d'aspirer l'air qui s'y trouve, par exemple à travers la conduite 39. Une dépression est ainsi créée à l'intérieur de la chambre 36 et se propage dans le tube 7, attirant les composants électroniques 8 qui s'y trouvent en direction de la pince 3. Les composants, par exemple des composants bloqués en cours d'extraction, sont ainsi redirigés en direction de la pince 3. En alternant de courtes périodes d'aspiration avec de rapides impulsions d'air comprimé, le système pneumatique génère un mouvement de va-et-vient des composants 8 dans le tube 7. Quelques mouvements alternés sont généralement suffisants pour résoudre la plupart des problèmes de blocage. Le processus d'extraction peut alors reprendre et l'air comprimé est à nouveau introduit de manière continue dans la chambre 36, jusqu'à extraction complète des composants.

Le dispositif d'extraction selon l'invention comprend ainsi de préférence des moyens de contrôle non représentés, par exemple des détecteurs optiques, pour détecter la présence de composants électroniques 8 dans le tube 7 et le transfert de composants du tube 7 sur le convoyeur linéaire 5. Les informations émanant de ces moyens de contrôle sont transmises au système de contrôle du dispositif. Lorsque le système de contrôle reçoit l'information que, durant une phase d'extraction, des composants électroniques 8 sont encore présents dans le tube 7 alors qu'aucun composant n'est transféré du tube 7 au convoyeur linéaire 5, le système de contrôle envoie au système pneumatique l'ordre de générer un mouvement de va-et-vient des composants selon le principe énoncé plus haut, puis de rétablir dans la chambre 36 la pression nécessaire à l'extraction des composants. Si le tube est débloqué, c'est-à-dire si un transfert de composants du tube 7 au convoyeur linéaire 5, est détecté par les moyens de contrôle, l'extraction normale des composants 8 est poursuivie. Dans le cas contraire, le système de contrôle ordonne une nouvelle série de mouvements alternés des composants.

Selon une variante de l'invention, la presse 4 est fixée sur un système vibratoire non représenté fixé directement ou indirectement sur la plaque de support 10. Le tube 7 est alors de préférence enserré entre le sabot 41 de la presse 4 et un sabot supplémentaire non représenté également fixé au système vibratoire, dont la surface supérieure est sensiblement à la même hauteur que la surface supérieure du support 45. Le système vibratoire permet ainsi de vibrer, de préférence rapidement et avec une faible amplitude, l'extrémité du tube 7 proche du convoyeur linéaire 5. En cas de blocage des composants électroniques 8 en cours d'extraction, le système vibratoire est avantageusement mis en marche parallèlement aux mouvements de va-et-vient des composants 8 dans le tube 7. Ces mouvements vibratoires de l'extrémité du tube 7 permettent en particulier de débloquer des composants électroniques 8 qui seraient coincés entre la sortie du tube 7 et l'introduction du convoyeur linéaire 5.

Selon la version de l'invention décrite plus haut, le dispositif d'extraction est particulièrement adapté à l'extraction de composants électroniques conditionnés dans des tubes dont les parois longitudinales sont fermées sur toute leur longueur, tels que par exemple les tubes 7 et 7' dont les profils sont représentés sur les figures 5 et 6. Le tube fermé étant étanche à l'air sur toute sa longueur, la surpression et/ou la dépression créées à l'intérieur de la chambre 36 par le système pneumatique s'y propage de manière optimale, permettant un bon contrôle du mouvement des composants électroniques à extraire.

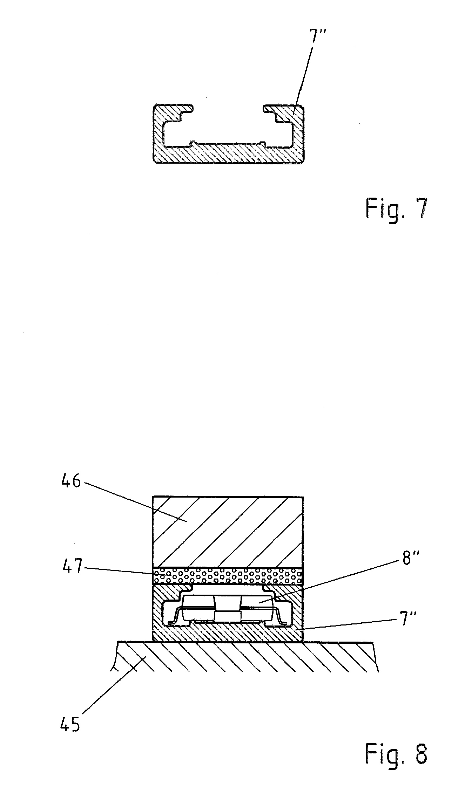

Or certains tubes utilisés pour le conditionnement des composants électroniques sont au moins partiellement ouverts, c'est-à-dire que leur profil est discontinu sur une partie au moins de leur longueur. La figure 7 illustre par exemple le profil d'un tube 7" ouvert sur sa partie supérieure. Ces tubes n'étant pas étanches à l'air sur toute leur longueur, les différences de pression générées par le système pneumatique dans la chambre 36 de la pince 3 ne se propagent efficacement que jusqu'à la première ouverture latérale rencontrée par les flux d'air correspondants, empêchant ainsi un contrôle efficace des composants se trouvant au-delà de cette ouverture. Si ce manque d'efficacité peut être compensé, pour le mouvement des composants en direction de la sortie du tube opposée à la pince 3, par une augmentation de la pression de l'air injecté dans la chambre 36, il est pratiquement impossible à compenser dans le cas où les composants doivent être redirigé par aspiration vers la pince 3.

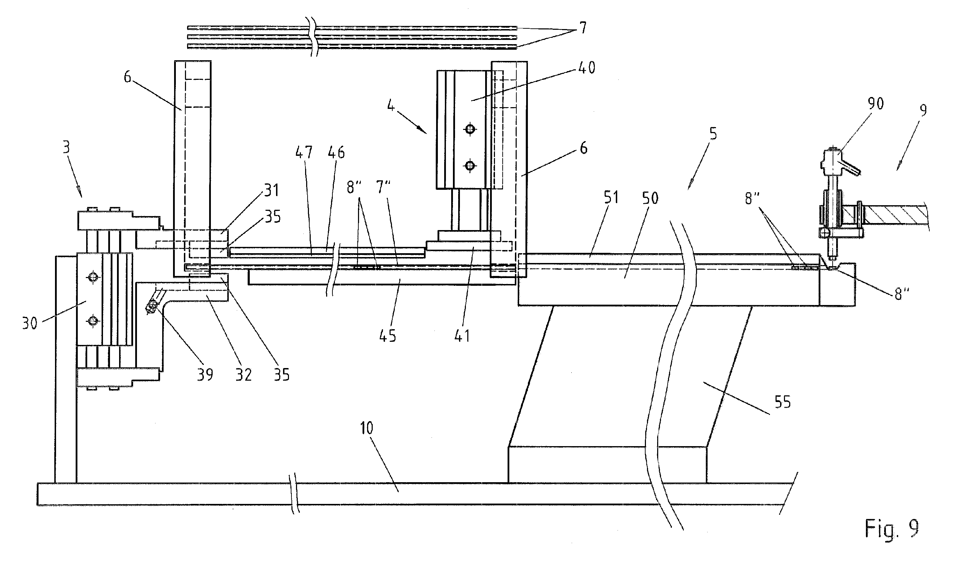

Les figures 8 et 9 illustrent ainsi à titre d'exemple une variante préférentielle du dispositif de l'invention adaptée à l'extraction de composants électroniques conditionnés dans des tubes ouverts, par exemple dans un tube 7" ouvert sur sa partie supérieure. Le dispositif d'extraction comprend alors de préférence des moyens mécaniques permettant de fermer au moins une partie de la ou des ouvertures du tube, assurant ainsi à ce dernier une étanchéité suffisante pour que les composants électroniques qui s'y trouvent en soient extraits efficacement, selon la méthode de l'invention.

Sans indication contraire, les mêmes éléments sont désignés par les mêmes références sur les figures 1 à 9.

Selon la variante illustrée par les figures 8 et 9, les moyens mécaniques pour fermer au moins partiellement le tube 7" comprennent de préférence un couvercle 46 qui est placé sur le tube 7" lorsque ce dernier est en position sur le support 45 pour l'extraction des composants 8" qu'il contient. La longueur du couvercle 46 est de préférence suffisante pour recouvrir toute la partie supérieure du tube 7" entre le sabot 41 et la pince 3. Afin d'augmenter encore l'étanchéité du tube 7", la surface inférieure du couvercle 46 est de préférence au moins partiellement recouverte d'un joint 47 en un matériau souple et étanche à l'air, par exemple en caoutchouc. Le joint 47 est toutefois de préférence suffisamment rigide pour éviter qu'il n'entre en contact avec les composants électroniques 8" se trouvant dans le tube 7" lorsque le couvercle 46 est abaissé, ce qui pourrait gêner leur extraction.

De préférence, le couvercle 46 est motorisé et ses mouvements sont commandés par le système de contrôle du dispositif. Le couvercle 46 est par exemple mû verticalement par un actuateur linéaire non représenté, par exemple par un vérin pneumatique ou par un actuateur électromagnétique, qui l'abaisse et l'appuie avec une force prédéterminée sur le tube 7" lorsque ce dernier est placé en position d'extraction sur le support 45. Les mouvements du couvercle 46 sont de préférence automatisées et coordonnés avec ceux de la pince 3 et du sabot 41 de manière à ce que les trois éléments soient refermés et/ou abaissés sur le tube 7' en même temps, peu avant l'extraction des composants 8" qui est ensuite effectuée et contrôlée de la manière expliquée plus haut. Une fois le tube 7" vidé de ses composants électroniques 8", le couvercle 46 est relevé, tandis que la pince 3 est ouverte et que le sabot 41 est relevé. Le tube 7" vide peut alors être évacué du support 45 pour être remplacé par un tube plein pour lequel les étapes décrites ci-dessus seront répétées.

Selon la variante décrite ci-dessus à titre d'exemple, les moyens mécaniques pour la fermeture au moins partielle du tube ouvert 7" comprennent un couvercle 46 disposé entre la pince 3 et le sabot 41. L'homme du métier comprendra cependant que d'autres formes de couvercles, motorisés ou non, sont possibles dans le cadre de l'invention. L'homme du métier comprendra également que l'étanchéité du tube ouvert peut être assurée à l'aide d'autres moyens mécaniques. Il est par exemple envisageable de dimensionner le sabot 41 afin qu'il recouvre la partie supérieure du tube depuis la pince 3 jusqu'à son extrémité opposée, de dimensionner la mâchoire supérieure 31 de la pince 3 afin qu'elle recouvre le tube ouvert jusqu'au sabot 41, ou de combiner ces deux éléments.

Dans le cadre de l'invention, le dispositif d'extraction peut également être adapté à l'extraction de composants électroniques depuis des tubes ouverts sur leur partie inférieure, par exemple en recouvrant au moins partiellement le support 45 d'une matière souple et étanche à l'air sur laquelle le tube ouvert est posé lors de l'extraction des composants, ou à des tubes ouverts sur les côtés en profilant par exemple le support 45 pour que le tube ouvert s'y insère entièrement ou en utilisant des couvercles spécifiques placés verticalement sur un ou deux côtés du tube ouvert. Toute combinaison des solutions évoquées ci-dessus est bien entendu envisageable dans le cadre de l'invention, en fonction de la taille et de la disposition des ouvertures des tubes à traiter.

Dans les exemples qui précèdent, le dispositif d'extraction de l'invention permet l'extraction de composants électroniques depuis un tube. L'homme du métier comprendra aisément qu'il est envisageable d'adapter le dispositif d'extraction de l'invention afin qu'il puisse extraire simultanément les composants électroniques de plusieurs tubes en parallèle. Le dispositif est alors équipé de plusieurs pinces 3 et de plusieurs sabots 41 pour maintenir le nombre désiré de tubes. Il est également possible de prévoir des pinces et des sabots adaptées au maintien simultané de plusieurs tubes. La pince possède alors soit une seule chambre pressurisée liée hermétiquement avec tous les tubes qu'elle enserre, soit plusieurs chambres liées chacune à un seul tube, permettant ainsi un meilleur contrôle de l'extraction des composants électroniques de chaque tube.

Dans le cas d'un dispositif d'extraction pouvant traiter une pluralité de tubes en parallèle, le dispositif d'alimentation de l'invention est également adapté à recevoir les composants électroniques extraits de ces tubes pour les mettre à disposition, par exemple, d'une ou de plusieurs lignes de traitement. Le dispositif d'alimentation est alors par exemple équipé d'un nombre correspondant de convoyeurs linéaires parallèles ou d'un convoyeur unique possédant plusieurs entrées et un seul point de sortie.

## Revendications

1. Méthode pour l'extraction de composants électroniques (8, 8', 8") conditionnés dans un tube (7, 7', 7") rectiligne facilitant leur transport,
lesdits composants électroniques (8, 8', 8") étant extraits dudit tube (7, 7', 7") par génération d'une surpression à l'une des extrémités dudit tube (7, 7', 7") à l'aide de moyens pneumatiques,
**caractérisée en ce que** l'extraction correcte desdits composants est contrôlée automatiquement,
et par une étape de génération d'une dépression à ladite extrémité du tube et/ou de vibration de l'autre extrémité du tube en cas d'extraction incorrecte desdits composants (8).

2. Méthode selon l'une des revendications précédentes, comprenant une étape de génération d'une dépression à ladite une des extrémités dudit tube (7, 7', 7") pour inverser le sens de circulation desdits composants électroniques (8, 8', 8") dans ledit tube (7, 7', 7").

3. Méthode selon l'une des revendications précédentes, l'extraction correcte desdits composants étant contrôlée par des détecteurs optiques.

4. Méthode selon l'une des revendications précédentes, ledit tube (7") comprenant au moins une ouverture sur sa longueur, ladite méthode comprenant une étape de fermeture au moins partielle de ladite au moins une ouverture.

5. Méthode selon la revendication précédente, ladite étape de fermeture étant effectuée à l'aide de moyens mécaniques de fermeture (46, 47).

6. Méthode selon la revendication précédente, ledit tube (7") comprenant au moins une ouverture sur sa surface supérieure, ladite étape de fermeture comprenant le recouvrement de ladite surface supérieure par un couvercle (46).

7. Méthode selon l'une des revendications précédentes, comprenant l'extraction simultanée de composants électroniques (8, 8', 8") à partir d'une pluralité de tubes (7, 7', 7").

8. Dispositif pour l'extraction de composants électroniques (8, 8', 8") conditionnés dans un tube (7, 7', 7") rectiligne facilitant leur transport, comprenant un système pneumatique permettant de créer une surpression à l'une des extrémités dudit tube (7, 7', 7") pour l'extraction desdits composants électroniques (8, 8', 8") hors dudit tube (7, 7', 7") ;
**caractérisé par** des moyens de contrôle pour le contrôle automatique de l'extraction desdits composants électroniques (8, 8', 8") hors dudit tube (7, 7',7"),
et par des moyens pour générer une dépression à ladite une des extrémités dudit tube (7, 7', 7") et/ou pour vibrer l'autre extrémité en cas de détection d'extraction incorrecte desdits composants électroniques

9. Dispositif d'extraction selon la revendication 8, comprenant une pince pour lier hermétiquement ladite une des extrémités dudit tube (7, 7', 7") audit système pneumatique.

10. Dispositif d'extraction selon la revendication précédente, ladite pince (3) comprenant une matière compressible et déformable (35) pour épouser le profil extérieur dudit tube (7, 7', 7") lorsque ladite pince (3) enserre ladite une des extrémités.

11. Dispositif d'extraction selon l'une des revendications 9 à 10, ladite pince (3) formant une chambre (36) reliée audit système pneumatique et hermétiquement liée à ladite une des extrémités lorsque ladite pince (3) enserre ladite une des extrémités.

12. Dispositif d'extraction selon l'une des revendications 8 à 11, ledit système pneumatique étant agencé pour générer un mouvement de va-et-vient desdits composants électroniques (8, 8', 8") dans ledit tube (7, 7', 7").

13. Dispositif d'extraction selon la revendication 8, lesdits moyens de contrôle comprenant au moins un détecteur optique.

14. Dispositif d'extraction selon l'une des revendications 8 à 13, comprenant des moyens mécaniques (46, 47) permettant de fermer au moins partiellement au moins une ouverture dudit tube (7").

15. Dispositif d'extraction selon la revendication précédente, ladite au moins une ouverture étant placée sur la surface supérieure dudit tube (7"), lesdits moyens mécaniques comprenant un couvercle (46).

16. Dispositif d'extraction selon l'une des revendications 8 à 15, pour l'extraction de composants électroniques (8, 8', 8") simultanément à partir d'une pluralité de tubes (7, 7', 7").
